# EUROPEAN PATENT SPECIFICATION

(11) **EP 2 669 935 B1**
(45) Date of publication and mention of the grant of the patent: **22.04.2020**
(21) Application number: 12191602.7
(22) Date of filing: 07.11.2012
(51) Int. Cl.: H01L 21/48, H01L 23/498

(54) **Packaging substrate having interposer**
Verpackungssubstrat mit Interposer
Substrat d'emballage ayant un interposeur

(30) Priority: 01.06.2012 TW 101210641
(43) Date of publication of application: 04.12.2013
(73) Proprietor: Unimicron Technology Corp., Taoyuan (TW)
(72) Inventor: Tzyy-Jang, Tseng, 300 Hsinchu City (TW); Dyi-Chung, Hu, 310 Hsinchu County (TW)
(74) Representative: Becker & Kurig Partnerschaft Patentanwälte PartmbB

(56) References cited:
- US-A1- 2006 076 659
- US-A1- 2010 025 081
- US-A1- 2010 072 588
- US-A1- 2010 081 236
- US-A1- 2010 301 474

## Description

### BACKGROUND OF THE INVENTION

### Field of the Invention

The present invention is directed to a packaging substrate, and more particularly to a packaging substrate having an interposer.

### Description of Related Art

US-Patent Applications US2010/025081 A1 and US2010/081236 A1 disclose prior art packaging substrates.

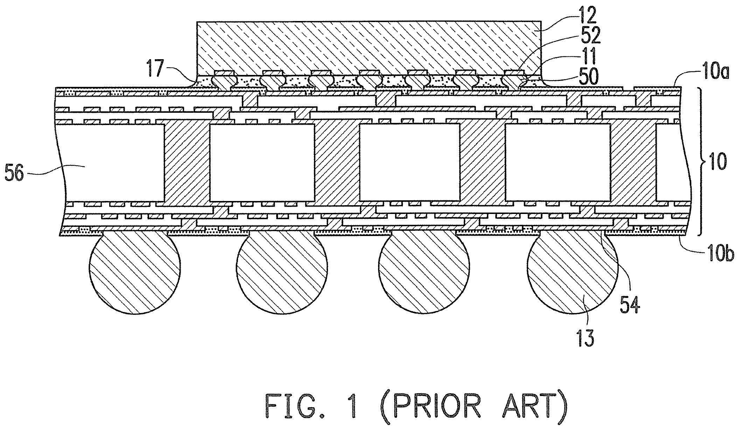

Referring to FIG. 1, FIG. 1 is a sectional schematic view illustrating a flip-chip packaging structure in the related art. In a fabricating process of the packaging structure, a bismaleimide-triazine (BT) packaging substrate 10 having core substrates 56, a first surface 10a and a second surface 10b is provided first. Flip-chip solder pads 50 are formed on the first surface 10a of the packaging substrate 10 and further electrically connected with electrode pads 52 of a semiconductor chip 12 through solder bumps 11. Then, an underfill 17 is formed between the first surface 10a of the packaging substrate 10 and the semiconductor chip 12 to cover the solder bumps 11. In addition, the second surface 10b of the packaging substrate 10 has ball-mounting pads 54 for being electrically connected with another electronic apparatus (not shown), such as a printing circuit board, through solder balls 13.

However, in order to enhance electrical performance of the semiconductor chip 12, during a back-end of line (BEOL) of the semiconductor chip 12, a dielectric material with an extreme low-k dielectric (ELK) or an Ultra low-k (ULK) is commonly adopted. However, the low-k dielectric material is porous and brittle. Therefore, while performing reliability thermal cycle test after the flip-chip packaging is performed. joints formed by the solder bumps 11 cannot withstand thermal stress, which results in fracture due to overly large difference of thermal expansion coefficients between the packaging substrate 10 and the semiconductor chip 12, such that product reliability is reduced.

Furthermore, with the trend of electronic products toward having compact sizes and improved functions, wiring density of the semiconductor chip 12 gets higher and higher, and a nano-size is used as a unit. Thus, an interval between each of the electrical connect pads 52 becomes smaller. However, the interval between the flip-chip solder pads 50 of the packaging substrate 10 in the related art uses a micron-size as a unit and cannot be minified to the size corresponding to the interval between the electrical connect pads 52. As a result, the semiconductor chip 12 has the high wiring density, but no suitable packaging substrate so that electronic products cannot effectively produced.

Accordingly, how to overcome problems in the related art has become a major concern recently.

### SUMMARY OF THE INVENTION

The present invention is directed to a packaging substrate according to claim 1, having an interposer capable of resolving a problem caused by a difference of thermal expansion coefficients.

The present invention is directed to a packaging substrate having an interposer, which includes a multilayered interconnect board, an insulation supporting layer, an interposer, a compliant layer and a redistribution layer. The multilayered interconnect board has a first surface and a second surface opposite to each other. The insulation supporting layer is disposed on the first surface of the multilayered interconnect board and has an opening region. A portion of the first surface is exposed at the opening region. The interposer is disposed on the first surface at the opening region and has a third surface and a fourth surface opposite to each other. The third surface of the interposer faces the first surface of the multilayered interconnect board. A stress releasing gap is between an outer-sidewall of the interposer and an inner-sidewall of the opening region. The stress releasing gap is an un-filled empty space. The compliant layer is disposed between the third surface of the interposer and the first surface of the multilayered interconnect board. The interposer has a plurality of through holes and a plurality of conductive posts correspondingly disposed in the through holes. The conductive posts penetrate the compliant layer and electrically connect with the multilayered interconnect board. The redistribution layer is disposed on the fourth surface of the interposer and electrically connected with the conductive posts.

In an embodiment of the present invention, the packaging substrate further includes a process termination piece disposed on a portion of the first surface and exposed at the stress releasing gap. Additionally, the process termination piece is a metal ring piece.

In an embodiment of the present invention, a material of the compliant layer is polyimide, polybenzoxazole or silica gel.

In an embodiment of the present invention, a material of the interposer includes silicone, glass or ceramic.

In an embodiment of the present invention, a material of the insulation supporting layer includes epoxy resin.

In an embodiment of the present invention, an insulation layer is disposed on the first surface of the multilayered interconnect board. The insulation supporting layer contacts the insulation layer. The conductive posts penetrate the insulation layer and electrically connect with a circuit layer of the multilayered interconnect board. Moreover, an end part of the conductive posts is, for example, embedded in the circuit layer.

To sum up, both the stress releasing gap and the compliant layer of the present invention can buffer a difference of thermal expansion coefficients between the interposer and its surrounding components so as to improve product reliability.

In order to make the aforementioned and other features and advantages of the invention comprehensible, several exemplary embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a sectional schematic view illustrating a flip-chip packaging structure in the related art.
FIG. 2 is a sectional schematic view illustrating packaging substrate having an interposer wherein the stress releasing gap is filled with a buffering material.
FIG. 3A through FIG. 3C are schematic views illustrating a portion of steps of a process fabricating the packaging substrate having the interposer depicted in FIG. 2.

### DETAILED DESCRIPTION OF DISCLOSED EMBODIMENTS

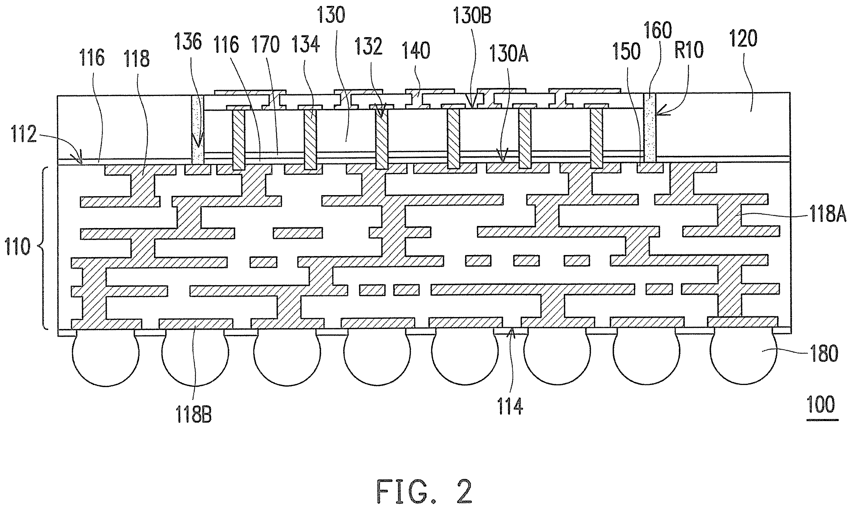

FIG. 2 is a sectional schematic view illustrating packaging substrate having an interposer wherein the stress releasing gap is filled with a buffering material. Such a packaging substrate is not part of the claimed invention. Referring to FIG. 2. a packaging substrate 100 of the present embodiment includes a multilayered interconnect board 110. an insulation supporting layer 120, an interposer 130, a compliant layer 170 and a redistribution layer 140. The multilayered interconnect board 110 has a first surface 112 and a second surface 114 opposite to each other. The first surface 112 and the second surface 114 are approximately parallel and located at two opposite sides of the multilayered interconnect board 110. The insulation supporting layer 120 is disposed on the first surface 112 and has an opening region R10. A portion of the first surface 112 is exposed at the opening region R10. The interposer 130 is disposed on the first surface 112 at the opening region R10. The interposer 130 has a third surface 130A and a fourth surface 130B opposite to each other. The third surface 130A and the fourth surface 130B are approximately parallel and located at two opposite sides of interposer 130. The third surface 130A of the interposer 130 faces the first surface 112 of the multilayered interconnect board 110.

There is a stress releasing gap 136 between an outer-sidewall of the interposer 130 and an inner-sidewall of the opening region R10. In other words, both the interposer 130 and the insulation supporting layer 120 are disposed on the first surface 112 of the multilayered interconnect board 110, and since the stress releasing gap 136 exists therebetween, they do not contact with each other. Accordingly, when heated, even though the difference of thermal expansion coefficients results in different thermal expansions of sizes of the interposer 130 and the insulation supporting layer 120, the stress releasing gap 136 can be used as a buffer to avoid the interposer 130 and the insulation supporting layer 120 contacting with each other so that damage from the stress when contacting is prevented.

The compliant layer 170 is disposed between the third surface 130A of the interposer 130 and the first surface 112 of the multilayered interconnect board 110. The interposer 130 has a plurality of through holes 132 and a plurality of conductive posts 134 correspondingly disposed in the through holes 132. The conductive posts 134 penetrate the compliant layer 170 and electrically connect with the multilayered interconnect board 110. In particular, the multilayered interconnect board 110 has a plurality of interconnects (not shown), and the conductive posts 134 electrically connect with these interconnects. The redistribution layer 140 is disposed on the fourth surface 130B of the interposer 130 and is electrically connected with the conductive posts 134. Due to the existence of the compliant layer 170, when heated, even though the difference of thermal expansion coefficients results in different thermal expansions of the sizes of the interposer 130 and the multilayered interconnect board 110, the compliant layer 170 can also be used as the buffer so that damage of the connections between the conductive posts 134 and the multilayered interconnect board 110 owing to shear force is prevented.

In view of the foregoing, the packaging substrate 100 of the present embodiment can effectively mitigate the damage resulted from the difference of thermal expansion coefficients to ensure that internal circuits are in good condition so as to improve product reliability.

A material of the compliant layer 170 of the present embodiment is polyimide, polybenzoxazole, silica gel or any other material. The thermal expansion coefficient of the compliant layer 170 is, for example, between the thermal expansion coefficient of the interposer 130 and the thermal expansion coefficient of the multilayered interconnect board 110. A buffering material 160 may also be applied to fill the stress releasing gap 136, which also assists to avoid the interposer 130 and the insulation supporting layer 120 contacting with each other so that the damage from the stress when contacting is prevented. A material of the interposer 130 is, for example, silicone, glass, ceramic or any other material. A material of the insulation supporting layer 120 is, for example, epoxy resin or any other material.

In the present embodiment, an insulation layer 116 is disposed on the first surface 112 of the multilayered interconnect board 110. The insulation supporting layer 120 contacts the insulation layer 116. The conductive posts 134 penetrate the insulation layer 116 and electrically connect with a circuit layer 118 of the multilayered interconnect board 110. For example, an end part of the conductive posts 134 is embedded in the circuit layer 118. Specifically, the first surface 112 of the multilayered interconnect board 110 is substantially covered by the whole insulation layer 116, and only a portion thereof is exposed at the circuit layer 118 under the insulation layer 116. Thus, both the compliant layer 170 and the insulation supporting layer 120 contact the insulation layer 116. The multilayered interconnect board of the present embodiment is approximately formed by stacking multiple circuit layers 118 and the insulation layers between the circuit layers 118, and the circuit layers 118 are connected with each other using conductive vias 118A. Besides, a plurality of solder balls 180 may be further disposed on the second surface 114 of the multilayered interconnect board 110. The circuit layers 180 on the second surface 114 have a plurality of ball-mounting pads 118B. The solder balls 180 are disposed on the ball-mounting pads 118B of the second surface 114 and configured to connect with an external apparatus, such as a printing circuit board.

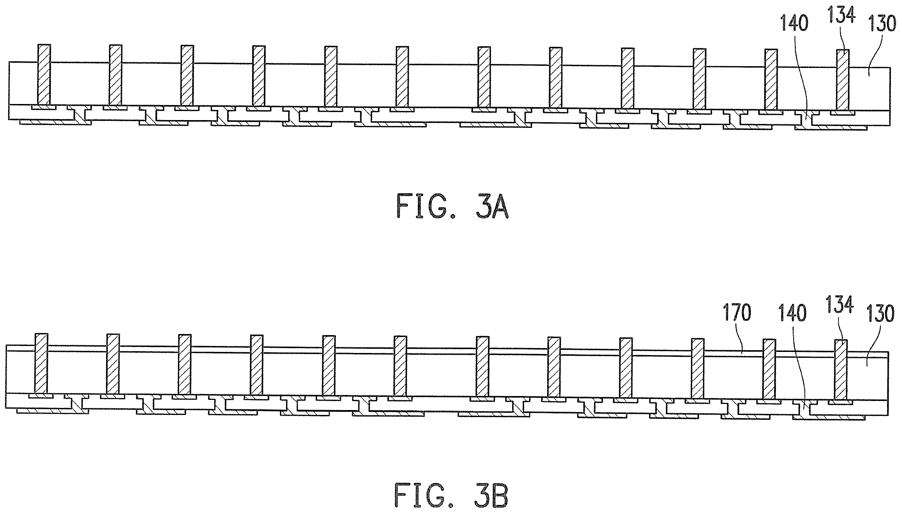

FIG. 3A through FIG. 3C are schematic views illustrating a portion of steps of a process fabricating the packaging substrate having the interposer depicted in FIG. 2. Referring to FIG. 3A, first, the interposer 130 is provided. The redistribution layer 140 is formed on the fourth surface 130B of the interposer 130. The through holes 132 of the interposer 130 and conductive posts 134 disposed in the through holes 132 are also formed. At this time, the conductive posts 134 protrude from the third surface 130A of the interposer 130.

Next, referring to FIG. 3B, a dry-film compliant layer 170 is pressed onto the third surface 130A of the interposer 130, and the conductive posts 134 penetrate the compliant layer 170. Otherwise, the compliant layer 170 may also be liquid and disposed on the third surface 130A by a coating method. Then, the liquid compliant layer 170 is solidified by heat or any other method, and finally, the compliant layer 170 is penetrated by the conductive posts 134.

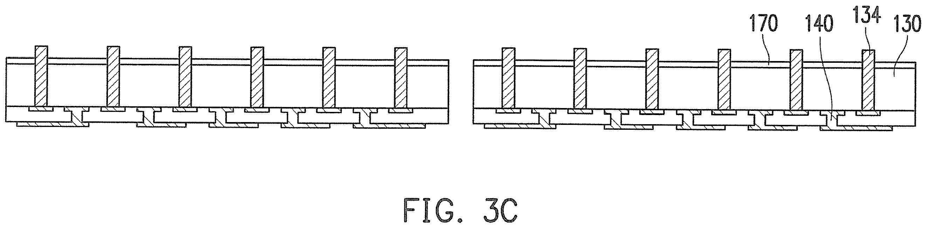

Afterward, referring to FIG. 3C, the semi-finished product produced as the above is cut into pieces according to a desired size.

Then, referring to FIG. 2, the semi-finished product depicted in FIG. 3C is, for example, packaged using a common packaging material in the center to form a plate. Next, the insulation layer 116, the circuit layer 118 and the conductive via 118A are formed by a general built-up method so as to finish the multilayered interconnect board 110. Afterward, for example, the packaging material surrounding the interposer 130 is removed by adopting laser or any other processing method to form the stress releasing gap 136 while insulation supporting layer 120 is formed by the rest of the packaging material. Finally, the solder balls 180 are formed.

During the step of forming the stress releasing gap 136, in order to avoid damaging the multilayered interconnect board 110, a process termination piece 150 may be disposed on a portion of the multilayered interconnect board 110 corresponding to the stress releasing gap 136. Thus. during the process of removing the packaging material surrounding the interposer 130 by adopting laser or any other processing method, the process step is terminated at the process termination piece 150. According to the finally produced packaging substrate 100, the process termination piece 150 is disposed on a portion of the first surface 112 and exposed at the stress releasing gap 136. The process termination piece 150 may be a metal ring piece or adopt any other suitable design. The process termination piece 150 may be formed simultaneously while the circuit layer 118 close to the first surface 112 of the multilayered interconnect board 110 is formed.

Based on the above, the stress releasing gap and the compliant layer of the present invention are designed to form a stress buffer area between the interposer, the multilayered interconnect board and the insulation supporting layer. Accordingly, a thermal stress generated by the difference of thermal expansion coefficients between the interposer, the multilayered interconnect board and the insulation supporting layer can be lowered down so that the completeness of all electrical connection can be ensured to improve product reliability.

## Claims

1. A packaging substrate (100) having an interposer (130), comprising:
a multilayered interconnect board (110), having a first surface (112) and a second surface (114) opposite to each other;
an insulation supporting layer (120), disposed on the first surface (112) and having an opening region (R10), wherein a portion of the first surface (112) is exposed at the opening region (R10);
an interposer (130), disposed on the first surface (112) at the opening region (R10) and having a third surface (130A) and a fourth surface (130B) opposite to each other, wherein the third surface (130A) of the interposer (130) faces the first surface (112) of the multilayered interconnect board (110), and a stress releasing gap (136) is between an outer-sidewall of the interposer (130) and an inner-sidewall of the opening region (R10),
a compliant layer (170), disposed between the third surface (130A) of the interposer (130) and the first surface (112) of the multilayered interconnect board (110), wherein the interposer (130) has a plurality of through holes (132) and a plurality of conductive posts (134) correspondingly disposed in the through holes (132), and the conductive posts (134) penetrate the compliant layer (170) and electrically connect with the multilayered interconnect board (110); and
a redistribution layer (140), disposed on the fourth surface (130B) of the interposer (130) and electrically connected with the conductive posts (134), **characterized in that**
the stress releasing gap (136) is an un-filled empty space.

2. The packaging substrate (100) having the interposer (130) according to claim 1, further comprising a process termination piece (150) disposed on a portion of the first surface (112) and exposed at the stress releasing gap (136).

3. The packaging substrate (100) having the interposer (130) according to claim 2, wherein the process termination piece (150) is a metal ring piece.

4. The packaging substrate (100) having the interposer (130) according to claim 1, wherein a material of the compliant layer (170) is polyimide, polybenzoxazole or silica gel.

5. The packaging substrate (100) having the interposer (130) according to claim 1, wherein a material of the interposer (130) comprises silicone, glass or ceramic.

6. The packaging substrate (100) having the interposer (130) according to claim 1, wherein a material of the insulation supporting layer (120) comprises epoxy resin.

7. The packaging substrate (100) having the interposer (130) according to claim 1, wherein an insulation layer (116) is disposed on the first surface (112) of the multilayered interconnect board (110), the insulation supporting layer (120) contacts the insulation layer (116), and the conductive posts (134) penetrate the insulation layer (116) and electrically connect with a circuit layer (118) of the multilayered interconnect board (110).

8. The packaging substrate (100) having the interposer (130) according to claim 7, wherein an end part of the conductive posts (134) is embedded in the circuit layer (118).

## Patentansprüche

1. Packungssubstrat (100) mit einem Interposer (130), umfassend:
eine mehrschichtige Zwischenverbindungsplatte (110) mit einer ersten Oberfläche (112) und einer zweiten Oberfläche (114), die einander gegenüberliegen;
eine isolierende Trägerschicht (120), die auf der ersten Oberfläche (112) angeordnet ist und einen Öffnungsbereich (R10) aufweist, wobei ein Abschnitt der ersten Oberfläche (112) an dem Öffnungsbereich (R10) freiliegt;
einen Interposer (130), der auf der ersten Oberfläche (112) an dem Öffnungsbereich (R10) angeordnet ist und eine dritte Oberfläche (130A) und eine vierte Oberfläche (130B) aufweist, die einander gegenüberliegen, wobei die dritte Oberfläche (130A) der Zwischenlage (130) der ersten Oberfläche (112) der mehrschichtigen Zwischenverbindungsplatte (110) zugewandt ist, und sich ein spannungsbefreiender Spalt (136) zwischen einer Außenseitenwand des Interposers (130) und einer Innenseitenwand des Öffnungsbereichs (R10) befindet;
eine konforme Schicht (170), die zwischen der dritten Oberfläche (130A) des Interposers (130) und der ersten Oberfläche (112) der mehrschichtigen Zwischenverbindungsplatte (110) angeordnet ist, wobei der Interposer (130) eine Vielzahl von Durchgangslöchern (132) und eine Vielzahl von leitenden Pfosten (134) aufweist, die entsprechend in den Durchgangslöchern (132) angeordnet sind, und wobei die leitenden Pfosten (134) die konforme Schicht (170) durchdringen und elektrisch mit der mehrschichtigen Zwischenverbindungsplatte (110) verbunden sind; und
eine Umverteilungsschicht (140), die auf der vierten Oberfläche (130B) des Interposers (130) angeordnet und elektrisch mit den leitenden Pfosten (134) verbunden ist, **dadurch gekennzeichnet, dass** der spannungsbefreiende Spalt (136) ein ungefüllter, leerer Raum ist.

2. Packungssubstrat (100) mit dem Interposer (130) gemäß Anspruch 1, ferner umfassend ein Prozessabschlussstück (150), das auf einem Abschnitt der ersten Oberfläche (112) angeordnet und an dem spannungsbefreienden Spalt (136) freiliegt.

3. Packungssubstrat (100) mit dem Interposer (130) gemäß Anspruch 2, wobei das Prozessabschlussstück (150) ein Metallringstück ist.

4. Packungssubstrat (100) mit dem Interposer (130) gemäß Anspruch 1, wobei ein Material der konformen Schicht (170) Polyimid, Polybenzoxazol oder Kieselgel ist.

5. Packungssubstrat (100) mit dem Interposer (130) gemäß Anspruch 1, wobei ein Material des Interposers (130) Silikon, Glas oder Keramik umfasst.

6. Packungssubstrat (100) mit dem Interposer (130) gemäß Anspruch 1, wobei ein Material der isolierenden Trägerschicht (120) Epoxidharz umfasst.

7. Packungssubstrat (100) mit dem Interposer (130) gemäß Anspruch 1, wobei eine Isolierschicht (116) auf der ersten Oberfläche (112) der mehrschichtigen Zwischenverbindungsplatte (110) angeordnet ist, die isolierende Trägerschicht (120) die Isolierschicht (116) kontaktiert und wobei die leitenden Pfosten (134) die Isolierschicht (116) durchdringen und elektrisch mit einer Schaltungsschicht (118) der mehrschichtigen Zwischenverbindungsplatte (110) verbunden sind.

8. Packungssubstrat (100) mit dem Interposer (130) gemäß Anspruch 7, wobei ein Endteil der leitenden Pfosten (134) in die Schaltungsschicht (118) eingebettet ist.

## Revendications

1. Substrat d'emballage (100) ayant un interposeur (130), comprenant :
une carte d'interconnexion multicouche (110), ayant une première surface (112) et une deuxième surface (114) à l'opposé l'une de l'autre ;
une couche de support isolante (120), disposée sur la première surface (112) et comportant une région d'ouverture (R10), dans lequel une partie de la première surface (112) est exposée au niveau de la région d'ouverture (R10) ;
un interposeur (130), disposé sur la première surface (112) au niveau de la région d'ouverture (R10) et comportant une troisième surface (130A) et une quatrième surface (1308) à l'opposé l'une de l'autre, dans lequel la troisième surface (130A) de l'interposeur (130) fait face à la première surface (112) de la carte d'interconnexion multicouche (110), et un interstice de détente des contraintes (136) se situe entre une paroi latérale externe de l'interposeur (130) et une paroi latérale interne de la région d'ouverture (R10),
une couche souple (170), située entre la troisième surface (130A) de l'interposeur (130) et la première surface (112) de la carte d'interconnexion multicouche (110), dans lequel l'interposeur (130) comporte une pluralité de trous traversants (132) et une pluralité de montants conducteurs (134) disposés de manière correspondante dans les trous traversants (132), et les montants conducteurs (134) pénètrent dans la couche souple (170) et sont reliés de manière électrique à la carte d'interconnexion multicouche (110) ; et
une couche de redistribution (140), disposée sur la quatrième surface (130B) de l'interposeur (130) et reliée de manière électrique aux montants conducteurs (134), **caractérisé en ce que**
l'interstice de détente des contraintes (136) est un espace vide non rempli.

2. Substrat d'emballage (100) ayant l'interposeur (130) selon la revendication 1, comprenant en outre une pièce de terminaison de processus (150) disposée sur une partie de la première surface (112) et exposée au niveau de l'interstice de détente des contraintes (136).

3. Substrat d'emballage (100) ayant l'interposeur (130) selon la revendication 2, dans lequel la pièce de terminaison de processus (150) est une pièce annulaire métallique.

4. Substrat d'emballage (100) ayant l'interposeur (130) selon la revendication 1, dans lequel un matériau de la couche souple (170) est le polyimide, le polybenzoxazole ou le gel de silice.

5. Substrat d'emballage (100) ayant l'interposeur (130) selon la revendication 1, dans lequel un matériau de l'interposeur (130) comprend du silicone, du verre ou du céramique.

6. Substrat d'emballage (100) ayant l'lntèrposeur (130) selon la revendication 1, dans lequel un matériau de la couche de support isolante (120) comprend de la résine époxy.

7. Substrat d'emballage (100) ayant l'interposeur (130) selon la revendication 1, dans lequel une couche d'isolation (116) est disposée sur la première surface (112) de la carte d'interconnexion multicouche (110), la couche de support isolante (120) vient en contact avec la couche d'isolation (116), et les montants conducteurs (134) pénètrent dans la couche d'isolation (116) et sont reliés électriquement à la couche de circuit (118) de la carte d'interconnexion multicouche (110) .

8. Substrat d'emballage (100) ayant l'interposeur (130) selon la revendication 7, dans lequel une partie d'extrémité des montants conducteurs (134) est incorporée dans la couche de circuit (118).
